Europäisches Patentamt

European Patent Office

Office européen des brevets

(11) Veröffentlichungsnummer : **0 143 172**
**B1**

(12) **EUROPÄISCHE PATENTSCHRIFT**

(45) Veröffentlichungstag der Patentschrift :
25.05.88

(51) Int. Cl.⁴ : **H 03 F   3/387**, G 01 R 19/18

(21) Anmeldenummer : **84108903.0**

(22) Anmeldetag : **27.07.84**

(54) Schaltung zur potentialfreien Messung einer Gleichspannung.

(30) Priorität : **15.10.83 DE 3337589**

(43) Veröffentlichungstag der Anmeldung :
**05.06.85 Patentblatt 85/23**

(45) Bekanntmachung des Hinweises auf die Patenterteilung : **25.05.88 Patentblatt 88/21**

(84) Benannte Vertragsstaaten :
**BE FR GB NL**

(56) Entgegenhaltungen :
CH-A-   447 358
DD-A- 2 043 316
DE-A- 2 716 122
DE-A- 3 207 785
DE-B- 2 249 223
DE-C- 2 423 645

(73) Patentinhaber : DORNIER SYSTEM GmbH
Postfach 1360
D-7990 Friedrichshafen (DE)

(72) Erfinder : Denzinger, Wolfgang, Dipl.-Ing.
Warinstrasse 9
D-7990 Friedrichshafen 24 (DE)

(74) Vertreter : Landsmann, Ralf, Dipl.-Ing.
Kleeweg 3
D-7990 Friedrichshafen 1 (DE)

## Beschreibung

Die Erfindung betrifft eine Schaltung zur potentialfreien Messung einer Gleichspannung mit hohem Potentialunterschied zwischen Meßelektronik und zu messender Gleichspannung nach dem Oberbegriff des Anspruchs.

Bei potentialfreien Messungen einer Gleichspannung, bei welcher zwischen Meßelektronik und der zu messenden Spannung große Potentiaunterschiede bestehen, ist die Signalübertragung schwierig und aufwendig. Ein Beispiel dafür ist die Messung von Einzelspannungen einer Batterie mit großer Zellenzahl.

Aus der Praxis bekannte und auf dem Markt verfügbare potentialtrennende Operationsverstärker ermöglichen mittels optischer oder elektrotransformatorischer Signalübertragung die galvanische Trennung zwischen Ein- und Ausgang. Diese Verstärker haben aber den Nachteil, daß sie wegen der zweifachen potentialgetrennten Stromversorgung konstruktiv sehr aufwendig und teuer sind.

Aus der DD-A-2 04 316 und der DE-A-3 207 785 sind Vorrichtungen zur potentialfreien Messung von Gleichströmen bekannt, bei denen Trenntransformatoren verwendet werden. Potentialtrennende Transformatoren werden auch in der DE-B-2 249 223 und der CH-A-447 358 verwendet.

Die DE-A-2 716 122 beschreibt einen Leistungsverstärker bei dem zwei Transistoren thermisch gekoppelt sind.

Aus-der DE-C-2 423 645 ist eine Schaltung zur potentialfreien Messung einer Gleichspannung bekannt, die einen Transformator mit drei Wicklungen und drei Dioden aufweist. In die erste Wicklung wird ein gepulster Strom eingeprägt, die von diesem Strom in der zweiten Wicklung induzierte Spannung wird gemessen und bildet die an der dritten Wicklung anliegende, zu messende Spannung, ab. Diese Vorrichtung bildet den Oberbegriff des Patentanspruchs. Bei dieser Schaltung ist möglich, daß die Ströme in den für die Genauigkeit maßgebenden Dioden nicht gleich groß sind. Deshalb sind die Flußspannungen der Dioden in Durchlaßrichtung nicht konstant sondern stark abhängig von der zu messenden Spannung und der äußeren Beschaltung. Damit ist diese Schaltung nicht geeignet für eine Spannungsmessung mit Genauigkeiten im mV-Bereich.

Davon ausgehend ist es Aufgabe der Erfindung, die Schaltung dahingehend zu verbessern, daß auch kleine Spannungen mit einer Genauigkeit von wenigen mV gemessen werden können.

Zur Lösung der gestellten Aufgabe sind erfindungsgemäß die Merkmale des Anspruchs vorgesehen.

Die Funktionsweise der Erfindung besteht darin, daß die Spannungsmessung mit Hilfe eines mit drei Wicklungen versehenen Transformators erfolgt, bei welchem dessen Spannung beim Anlegen eines Strompulses aus zwei gepulsten Stromquellen die zu messende Gleichspannungsquelle begrenzt und durch den mit der Schaltung verbundenen minmalen elektronischen Aufwand die Herstellung derselben vereinfacht wird und Kosten eingespart werden. Die transformatorische Messung einer Gleichspannung ist nur durch Modulation einer Wechselspannung oder einer Pulsfolge möglich. Die Modulation erfolgt dabei über einen Transformator, dessen Spannung mittels eines Strompulses durch die zu messende Spannung begrenzt wird. Ein hierzu notwendiger Gleichrichter besitzt einen von seinem Arbeitspunkt und seiner Temperatur abhängigen Spannungsabfall. Wird der Spannungsabfall dieses Gleichrichters in der Meßelektronik durch einen zweiten Gleichrichter kompensiert, dem der gleiche Arbeitspunkt und thermische Gleichlauf aufgezwungen wird, so ist dieser Einfluss eliminiert.

Ein Ausführungsbeispiel ist folgend beschrieben und durch eine Skizze erläutert.

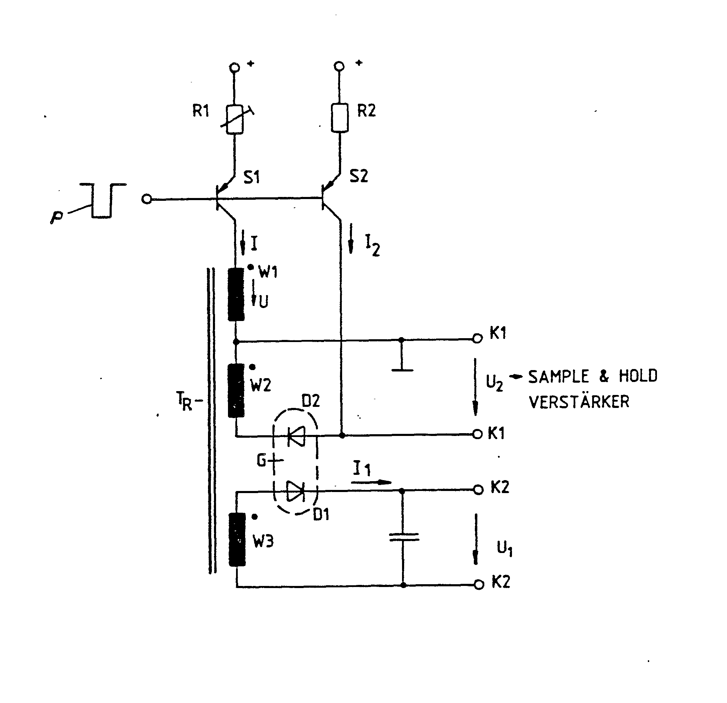

Die Figur zeigt eine Schaltung zur potentialfreien Spannungsmessung im Prinzip.

Bei einem mit drei Wicklungen $W_1$, $W_2$, $W_3$ gleicher Wicklungszahl ausgelegten Transformator TR ist die Wicklung $W_3$ über eine als Gleichrichter wirkende Diode $D_1$ mit der zu messenden Gleichspannung $U_1$ verbunden. In die Wicklungen $W_1$, $W_2$ werden durch einen Rechteckpuls P gemeinsam gesteuerte Stromquellen $S_1$, $S_2$ Ströme I, $I_2$ eingeprägt, die so eingestellt werden, dass folgende idealisierte Beziehung gilt:

$$I_1 = I_2 \text{ oder } I = I_1 + I_2$$

Damit ist sichergestellt, dass die Diode $D_1$ und die der Wicklung $W_2$ nachgeschaltete Diode $D_2$ den gleichen Arbeitspunkt aufweisen. Der thermische Gleichlauf der beiden Dioden $D_1$ und $D_2$ wird durch eine gute thermische Verkopplung oder ein sie gemeinsam verbindendes Gehäuse G erzwungen. Vom Transformator TR ausgehende Einflüsse des Magnetisierungsstromes und ein Ausgleichsfehler der Dioden $D_1$, $D_2$ wird durch entsprechendes Einstellen und Justieren des Stromes I und der Stromquelle $S_1$ mittels eines ihr vorgeschalteten Regelwiderstandes $R_1$ kompensiert. Der Stromquelle $S_2$ ist ein fest eingestellter Widerstand $R_2$ vorgeschaltet. Werden die Stromquellen $S_1$ und $S_2$ bzw. die von ihnen ausgehenden Ströme I und $I_2$ pulsförmig aktiviert, so wird in den Wicklungen $W_1$, $W_2$, $W_3$ eine Spannung U induziert, welche folgender Beziehung genügt:

$$U = U_1 + U_{D_1} = U_2 + U_{D_2}$$

Da die Gleichrichterspannungen $U_{D_1}$ und $U_{D_2}$ gleich groß sind, hat der Spannungspuls $U_2$ an den Klemmen $K_1$ die gleiche Amplitude, wie die an den Klemmen $K_2$ zu messende Gleichspannung $U_1$, und kann von dort mit einem Sample + Hold-Verstärker (siehe Pfeil) erfasst werden oder in einem Kondensator (nicht näher gezeigt) gespeichert und mit Hilfe eines Impedanzwandlers (nicht näher gezeigt) als Dauersignal gemessen werden.

Der Kondensator parallel zu der zu messenden Gleichspannung dient dazu, eventuelle Einflüsse von Leitungsimpedanzen zwischen dem Meßobjekt und der Meßschaltung zu eliminieren.

Praktische Messungen haben beispielsweise ergeben, dass eine Batteriezellenspannung von ca. 1,5 Volt mit einer Genauigkeit von 5 mV (ca. 3,3 %) über einen Temperaturbereich von ca. 80° C gemessen werden kann.

## Patentanspruch

Schaltung zur potentialfreien Messung einer Gleichspannung mit hohem Potentialunterschied zwischen Messelektronik und zu messender Gleichspannung, mit einem drei, bevorzugt gleiche Wicklungen enthaltenden Transformator (TR), wobei in Serie zur ersten Wicklung (W1) eine gepulste Stromquelle (S1) liegt, die der ersten Wicklung (W1) einen ersten Strompuls (I) einprägt, die in der zweiten Wicklung (W2) induzierte Spannung (U2) gemessen wird, an der dritten Wicklung (W3) die zu messende Spannung (U1) anliegt und zumindest im Kreis der zweiten Wicklung (W2) und der dritten Wicklung (W3) je eine Diode (D2 und D1) angeordnet sind, dadurch gekennzeichnet, daß in Serie zur zweiten Wicklung (W2) eine zweite, synchron mit der ersten Stromquelle (S1) gepulste Stromquelle (S2) liegt, die der zweiten Wicklung (W2) einen zweiten Strompuls (I2) einprägt, wobei die Amplitude des ersten Strompulses (I) so bemessen ist, daß in der dritten Wicklung (W3) ein dritter Strompuls (I1) mit gleicher Amplitude wie die des zweiten Strompulses (I2) in die zu messende Gleichspannungsquelle (U1) fließt, daß der zweite Strompuls (I2) in der zweiten Wicklung (W2) eine zur Induktion in der ersten Wicklung (W1) entgegengesetzte Induktion erzeugt, wodurch in den der zweiten und dritten Wicklung (W2, W3) nachgeschalteten Dioden (D1, D2) gleiche Spannungsabfälle erzwungen werden, so daß am Ausgang (K1) des Kreises mit der zweiten Wicklung (W2) ein Spannungspuls (U2) mit der gleichen Amplitude anliegt wie die zu messende Gleichspannung (U1) und daß die Dioden (D1, D2) thermisch verkoppelt sind.

## Claim

Isolation circuit for measuring a DC voltage with a large potential difference between the electronic measuring system and the DC voltage to be measured with a transformer (TR) containing three, preferably equal windings, whereby a pulsed current source (S1) is located in series with the first winding (W1), which impresses a first current pulse (I) on the first winding (W1), the voltage (U2) induced in the second winding (W2) is measured, the voltage (U1) to be measured is at the third winding (W3) and one diode (D2 and D1) is arranged in each case at least in the circuit of the second winding (W2) and the third winding (W3), characterised in that a second pulsed current source (S2) is located in step with the first current source (S1) in series with the second winding (W2), whereby the second current source impresses a second current pulse (I2) on the second winding (W2) and whereby the amplitude of the first current pulse (I) is chosen in such a way that in the third winding (W3) a third current pulse (I1) with the same amplitude as that of the second current pulse (I2) flows into the source of DC voltage (U1) to be measured, in that the second current pulse (I2) produces in the second winding (W2) an induction which is the inverse of the induction in the first winding (W1), whereby the same voltage drops are forced in the diodes (D1, D2) connected at the outlet side of the second and third winding (W2, W3), so that a voltage pulse (U2) with the same amplitude as the D.C. voltage (U1) to be measured is located at the outlet (K1) of the circuit with the second winding (W2) and in that the diodes (D1, D2) are coupled thermally.

## Revendication

Circuit d'isolation pour mesurer une tension continue avec une grande différence de potentiel entre l'électronique de mesure et la tension continue à mesurer, comprenant un transformateur (TR) avec trois enroulements, de préférence identiques, une source de courant pulsé (S1) étant montée en série avec le premier enroulement (W1) et lui appliquant une première impulsion de courant (I) ; la tension (U2) induite dans le deuxième enroulement (W2) étant mesurée ; la tension à mesurer (U1) étant appliquée au troisième enroulement (W3), et respectivement une diode (D2 et D1) étant placée au moins dans le circuit du deuxième enroulement (W2) et du troisième enroulement (W3), caractérisé en ce qu'une deuxième source de courant pulsé (S2) synchronisée avec la première source de courant (S1) et appliquant une deuxième impulsion de courant (I2) au deuxième enroulement (W2) est montée en série avec ce deuxième enroulement (W2), l'amplitude de la première impulsion de courant (I) étant telle que, dans le troisième enroulement (W3), une troisième impulsion de courant (I1) ayant la même amplitude que celle de la deuxième impulsion de courant (I2) passe dans la source de tension continue (U1) à mesurer ; que la deuxième impulsion de courant (I2) produit dans le deuxième enroulement (W2) une induction opposée à l'induction dans le premier enroulement (W1), ce qui a pour effet de provoquer des chutes de potentiel identiques dans les diodes (D1, D2) montées en aval des deuxième et troisième enroulements (W2, W3) de telle façon que la sortie (K1) du circuit avec le deuxième enroulement (W2) délivre une impulsion de tension (U2) ayant la même amplitude que la tension continue à mesurer (U1) ; et que les diodes (D1, D2) sont couplées thermiquement.